**Europäisches Patentamt**

**European Patent Office**

**Office européen des brevets**

(19)

(11) **EP 1 075 719 B1**

(12) **EUROPÄISCHE PATENTSCHRIFT**

(45) Veröffentlichungstag und Bekanntmachung des Hinweises auf die Patenterteilung:
**19.12.2001 Patentblatt 2001/51**

(51) Int Cl.⁷: $H01S\ 5/40$, $G02B\ 3/00$, $G02B\ 27/09$

(21) Anmeldenummer: **99924852.9**

(22) Anmeldetag: **30.04.1999**

(86) Internationale Anmeldenummer:
**PCT/EP99/02944**

(87) Internationale Veröffentlichungsnummer:
**WO 99/57791 (11.11.1999 Gazette 1999/45)**

(54) **OPTISCHES EMITTER-ARRAY MIT KOLLIMATIONSOPTIK**

OPTICAL EMITTER ARRAY WITH COLLIMATING OPTICS UNIT

ENSEMBLE EMETTEUR OPTIQUE A SYSTEME OPTIQUE DE COLLIMATION

(84) Benannte Vertragsstaaten:
**AT CH DE FR GB IT LI NL**

(30) Priorität: **30.04.1998 DE 19819333**

(43) Veröffentlichungstag der Anmeldung:
**14.02.2001 Patentblatt 2001/07**

(73) Patentinhaber:
• **Lissotschenko, Vitalij**
  **44149 Dortmund (DE)**
• **Hentze, Joachim**
  **59457 Werl (DE)**

(72) Erfinder: **HAUSCHILD, Dirk**
  **D-44229 Dortmund (DE)**

(74) Vertreter: **Basfeld, Rainer, Dr. Dipl.-Phys. et al**
  **Patentanwaltskanzlei Fritz Patent- und**
  **Rechtsanwälte Ostentor 9**
  **59757 Arnsberg-Herdringen (DE)**

(56) Entgegenhaltungen:
  **EP-A- 0 663 606      EP-A- 0 694 408**
  **US-A- 4 428 647      US-A- 5 414 559**

• **PATENT ABSTRACTS OF JAPAN vol. 1997, no. - , 29. August 1997 (1997-08-29) & JP 09 096760 A (MITSUI PETROCHEM IND LTD), 8. April 1997 (1997-04-08)**
• **PATENT ABSTRACTS OF JAPAN vol. 009, no. 068 (P-344), 28. März 1985 (1985-03-28) & JP 59 201016 A (MATSUSHITA DENKI SANGYO KK), 14. November 1984 (1984-11-14)**

**Beschreibung**

Die Erfindung betrifft ein optisches Emitter-Array mit Kollimationsoptik, bei dem eine Mehrzahl von ausgedehnten Emittern in x-Richtung nebeneinander angeordnet ist, die in dieser Richtung eine definierte Divergenz $\alpha_x$ haben und deren Mittenabstände $P_x$ größer sind als die Emittergröße $E_x$, und bei dem die Kollimationsoptik ein vor dem Emitter-Array angeordnetes Zylinderlinsen-Array aufweist, mit einer Mehrzahl von sammelnden Zylinderlinsenflächen, die jeweils einem Emitter zugeordnet sind und deren Zylinderachsen in y-Richtung liegen.

Derartige Emitter-Arrays mit einer Vielzahl von in x-Richtung langgestrecktlinienförmigen optischen Quellen der Breite $E_x$, die in Form einer linearen Matrix im Mittenabstand $P_x$ längs der x-Achse verlaufen, liegen beispielsweise bei Hochleistungs-Diodenlaserbarren vor. Die Gesamtbreite dieser Laserbarren bewegt sich in der Größenordnung von einigen Millimetern. Für konkrete Anwendungen ist es in der Regel erforderlich, dieses diskontinuierliche, aus separaten Linienabschnitten gebildete Strahlprofil einer Strahlformung zu unterziehen, wie etwa einer Homogenisierung oder einer geometrischen Querschnittstransformation. Der erste Schritt dieser Strahlaufbereitung ist in der Regel die Kollimation, deren Ziel eine möglichst weitgehende Divergenzreduktion über den gesamten aktiven Strahlquerschnitt ist. Ein solches Emitter-Array mit kollimationsoptik ist aus EP-A-0 694 408 bekannt.

Die Kollimation muß der stark anisotropen Divergenzverteilung von Halbleiterlasern Rechnung tragen. Der Divergenzwinkel $\alpha_y$ in y-Richtung ("fast-axis") ist nämlich relativ groß, während der Divergenzwinkel $\alpha_x$ in x-Richtung ("slow-axis") relativ dazu gering ist. Diesem Umstand begegnet man durch die Verwendung von Zylinderlinsen zur Parallelisierung in den unterschiedlichen Koordinaten. Bei einem Laserbarren mit einer Vielzahl von Emissionszentren erfolgt die fast-axis-Kollimation über eine einzige in x-Richtung liegende Zylinderlinse, die wegen der großen Divergenz möglichst dicht vor dem Emitter-Array fixiert wird. Zur Kollimation in der slow-axis wird ein Zylinderlinsen-Array eingesetzt, bei dem jeweils eine Zylinderlinse, deren Breite dem Mittenabstand $P_x$ der Emitter entspricht, in Strahlrichtung vor dem jeweiligen Emitter angebracht ist.

Eine gute Kollimation in x-Richtung ist grundsätzlich möglich, wenn die Brennweite F des Zylinderlinsen-Arrays möglichst groß zur Emitterbreite $E_x$ ist. Dies führt jedoch zu einer großen Baulänge, die insbesondere bei mikrooptischen Bauelementen nachteilig und deswegen unerwünscht ist. Dieses Vorgehen hat weiterhin den Nachteil, daß die von den Emittern ausgehenden Strahlbündel sich im Abstand a vor den Emitterflächen in x-Richtung überlagern und damit eine separate Divergenzreduktion für einzelne Emitter nicht mehr möglich ist.

Für eine separate Kollimation der einzelnen Emitter könnte zwar ein Zylinderlinsen-Array innerhalb der Überlagerungsdistanz a positioniert werden. Aus grundsätzlichen Überlegungen ist eine Divergenzreduktion unter der Annahme kleiner Divergenz in der slow-axis nur dann möglich, wenn für das Verhältnis von Emittergröße und Mittenabstand $E_x/P_x<0,5$ gilt. Bei Hochleistungs-Diodenlaser-Barren ist jedoch meist $E_x/P_x \geq 0,5$, so daß eine separate Kollimation mit einem einzigen Zylinderlinsen-Array grundsätzlich unmöglich ist.

Ein weiteres Problem ist, daß der Strahlquerschnitt nach wie vor eine diskontinuierliche Energieverteilung hat, also die hohe Brightness des Emitter-Arrays wegen der großen Inhomogenität nur bedingt nutzbar ist.

Aus der vorangehend erläuterten Problematik ergibt sich die Aufgabenstellung der Erfindung, ein optisches Emitter-Array, insbesondere einen Laserbarren, mit einer Kollimationsoptik zur Verfügung zu stellen, welches bei einer kleineren Baulänge eine bessere Strahlqualität liefert, insbesondere im Hinblick auf Parallelität und Homogenität des Strahlbündels.

Eine mögliche Lösung dieser Aufgabe besteht darin, daß ein erstes Zylinderlinsen-Array mit der Brennweite $F_1$ innerhalb des Überlagerungsabstands a vor den Emittern angeordnet ist, in dem sich die einzelnen von den Emittern ausgehenden Strahlbündel überlagern, wobei die Brennweite $F_1$ kleiner ist als der Überlagerungsabstand a, und daß ein zweites Zylinderlinsen-Array mit der Brennweite $F_2$ in Teleskopanordnung im Abstand $b = F_1 + F_2$ vor dem ersten Zylinderlinsen-Array angeordnet ist.

Das erste und das zweite Zylinderlinsen-Array bilden ein optisches Teleskop, wobei dessen Okularseite dem Emitter zugewandt ist. Da sich das dort befindliche erste Zylinderlinsen-Array maximal im Überlagerungsabstand a befindet, ergibt sich insgesamt eine sehr kurze Baulänge.

Dadurch, daß der Eingang der Kollimationsoptik sich im Überlagerungsabstand a befindet, ist eine separate Kollimation jedes einzelnen Emitters möglich. Der besondere Vorteil der Erfindung liegt darin, daß dennoch eine effektive Divergenzreduktion erfolgt, auch wenn $E_x/P_x \geq 0,5$ ist.

Dieser Vorteil der Kollimator-Teleskopanordnung beruht darauf, daß durch das erste Zylinderlinsen-Array zunächst eine virtuelle Vergrößerung des Emitters der Breite $E_x$ in einer Abbildungsebene auf die Breite des Mittenabstands $P_x$ erfolgt. Dies entspricht der effektiven Quellgröße für das zweite Zylinderlinsen-Array. Durch das konstante Strahlparameter-Produkt gemäß der Lagrange-Invariante (Apertur x sinus (Divergenz) = konstant) erfolgt eine Divergenzreduktion um den Vergrößerungsfaktor M der Teleskopanordnung. Die Näherung gilt für kleine Winkel, was bei der geringen Divergenz in dem slow-axis allerdings kein Problem ist.

Ein weiterer wesentlicher Vorteil der Kollimationsoptik liegt darin, daß durch die Quellenvergrößerung auf den Mittenabstand $P_x$ ein in x-Richtung kontinuierlich-linienförmiger Strahlquerschnitt erzeugt wird. Für ein gegebenes Emitter-Array ergibt sich somit eine hohe Brightness. Als Eingangsstrahl für anschließende Strahltransformationsvorrichtungen ist die homogene Intensitätsverteilung besonders vorteilhaft.

Bei dieser Ausführung gilt für den Überlagerungsabstand a:

$$a \leq \frac{(P_x - E_x)}{2 \tan(\alpha_x)}$$

In dieser Formel ist $\alpha_x$ die Divergenz in x-Richtung. Für die Brennweite $F_1$ des ersten Zylinderlinsen-Arrays wird folgender Wert eingesetzt:

$$F_1 = \frac{a}{\frac{E_x}{P_x} + 1}$$

Davon ausgehend berechnet sich die Brennweite $F_2$ des zweiten Zylinderlinsen-Arrays zu:

$$F_2 = F_1 \frac{P_x}{E_x}$$

In den vorbeschriebenen Formeln wird erstmals ein Zylinderlinsen-Kollimator mit zwei aufeinanderfolgenden Zylinderlinsen-Arrays angegeben, die zusammen ein abbildendes Teleskop bilden.

Die Kollimationseffizienz der vorgenannten Ausführungsform der Optik mit einer abbildenden Teleskopanordnung läßt sich alternativ durch eine Teleskopanordnung mit Fourier-Transformation und Feldlinse realisieren, bei der vor den Emittern E im Abstand $z_1$, der kleiner ist als der Überlagerungsabstand a, in dem sich die einzelnen von den Emittern E ausgehenden Strahlen überlagern, ein erstes Zylinderlinsen-Array A angeordnet ist und im Abstand T vor dem Zylinderlinsen-Array A ein zweites Zylinderlinsen-Array B, wobei die Zylinderlinsen der Arrays A und B jeweils zusammen eine Bikonvex-Linse mit resultierender Brennweite $F_r=F_A$ und Hauptebenenabstand $T=F_A$ bilden. Diese erfindungsgemäße Anordnung ist in Anspruch 9 definiert.

Für die Kollimation gilt bezüglich des Abstands zum ersten Zylinderlinsen-Array A dieselbe Bedingung wie bereits bei der abbildenden Teleskopanordnung, nämlich daß sich die von benachbarten Emittern E ausgehenden Strahlbündel nicht überlagern dürfen.

Im Unterschied zur ersten Variante der Erfindung erfolgt durch das erste Zylinderlinsen-Array A jedoch keine Abbildung, sondern eine Fourier-Transformation. Das zweite Zylinderlinsen-Array B hat in dieser Anordnung die Funktion einer Feldlinse

Diese Ausführungsform geht davon aus, daß die maximale Brennweite $F_A$ theoretisch nur dann erreicht werden kann, wenn $E_x=0$ ist. Tatsächlich sind die Emitter E jedoch als ausgedehnte Quellen zu betrachten, daß gelten muß: $0 < Z_1 < F_A$, um die Bedingung zu erfüllen, daß sich von benachbarten Emittern ausgehende Strahlen vor der Kollimationsoptik nicht überlagern. Gemäß der vorliegenden Ausführung der Erfindung wird dies dadurch erreicht, daß die Kollimation insgesamt über eine Bikonvex-Linse mit der resultierenden Brennweite F, erfolgt, deren Hauptebenenabstand $T = F_A/n$ ist (mit n=1 für Luft). In dieser Konfiguration dient die zweite Linse B als Feldlinse.

Aus der Beziehung für zwei dünne Linsen mit den Brennweiten $F_A$ und $F_B$ gilt für die resultierende Brennweite F. des Kollimationssystems:

$$F_r = \frac{(F_A F_B)}{F_A + F_B - \frac{T}{n}} \qquad \text{mit T/n= } F_A \text{ folgt: } F_r = F_A$$

Außerdem gilt mit T/n = $F_A$:

$$z_1 = F_A \left[ 1 - \frac{F_A}{F_B} \right] \quad \text{bzw.} \quad \frac{1}{F_B} = \frac{1}{F_A} - \frac{z_1}{F_A^2} \quad .$$

Mit der resultierenden Brennweite $F_r$ erhält man dabei für den Abstand zwischen dem Emitter E und dem ersten Zylinderlinsenarray A einen flexibel wählbaren Abstand $z_1$. Dieser wird durch die Brennweite $F_B$ des zweiten Arrays B, welches als Feldlinse dient, gemäß dem vorangehenden Zusammenhang kompensiert.

Bei der zuletzt genannten Bikonvex-Linsenanordnung ist die erste Linsenfläche, welche durch das erste Zylinderlinsen-Array A gebildet wird, für die Fourier-Transformation der Strahlbündel zuständig. Die zweite Linsenfläche, welche durch das zweite Zylinderlinsen-Array B gebildet wird, trägt als Feldlinse zu einer Verringerung des Abstrahlwinkels der Strahlbündel bei.

Unter bestimmten Bedingungen, wenn bei den Emitter-Arrays die einzelnen Emitter E in x-Richtung sehr klein sind, ist es im Zusammenhang mit der Übertragung einer möglichen guten Brightness zweckmäßig, zunächst die Divergenz in der fast-axis, d. h. in y-Richtung zu reduzieren und anschließend die slow-axis zu kollimieren. Dies läßt sich erfindungsgemäß dadurch erreichen, daß zwischen den Emittern E und dem Zylinderlinsen-Array A eine Zylinderlinsenfläche C angeordnet ist, deren Zylinderachse in x-Richtung liegt, d. h. parallel zur Längsachse der Emitter E. Dadurch, daß das erste Zylinderlinsen-Array A und die dritte Zylinderlinsenfläche C zu einem monolithischen Baustein zusammengefaßt sind, ergibt sich eine vorteilhaft geringe Zahl von Linsenoberflächen.

Zur Beseitigung der Restdivergenz in y-Richtung, d. h. in der fast-axis, kann zwischen dem ersten Zylinderlinsen-Array A und dem zweiten Zylinderlinsen-Array B eine vierte Zylinderlinsenfläche angeordnet sein, deren Zylinderachse in x-Richtung liegt. Daraus ergeben sich dieselben Vorteile, wie vorangehend bereits bei den Zylinderlinsen-Arrays A und der Zylinderlinse C angegeben. Zweckmäßigerweise sind auch das zweite Zylinderlinsen-Array B und die vierte Zylinderlinsenfläche D zu einem monolithischen Baustein zusammengefaßt.

Ausgehend von derselben zugrundeliegenden Problematik gibt die Erfindung eine alternative Ausführungsform an, welche ebenfalls zwei aufeinanderfolgende Zylinderlinsen-Arrays zur slow-axis-Kollimation aufweist, die optisch jedoch abweichend geschaltet sind. Im einzelnen wird hierbei vorgesehen, daß das erste Zylinderlinsen-Array mit der Brennweite $F_A$ im Abstand c, der klein ist gegenüber $F_A$, vor den Emittern angeordnet ist, und daß ein zweites Zylinderlinsen-Array mit derselben Brennweite $F_A$ im Abstand dieser Brennweite $F_A$ zum ersten Zylinderlinsen-Array angeordnet ist.

Bei dieser Ausführung der Erfindung, die durch Anspruch 1 definiert ist, handelt es sich um eine Fourier-Anordnung, bei der keine Abbildung wie beim konventionellen Teleskop erfolgt. Dabei wird in einer Zwischenebene durch das erste Zylinderlinsen-Array eine Quelle für das zweite Zylinderlinsen-Array erzeugt, deren Größe aufgrund der Fourier-Transformation abhängig ist von der Divergenz der ursprünglichen Quelle, das heißt den Emittern des Laserbarrens.

Diese Anordnung, die man als Zylinderlinsen-Fourier-Teleskop bezeichnen kann, ist hinsichtlich der Kollimation ebenso effektiv wie die erstgenannte klassische Teleskopanordnung. Darüber hinaus ergeben sich besondere Vorteile bei kleinen Emittergrößen $E_x$ und geringen Abständen $P_x$. Hierbei ist nämlich die Überlagerungsdistanz a mitunter so klein, daß die Überlagerung in der slow-axis bereits in der üblicherweise vorgeschalteten Kollimations-Zylinderlinse für die fast-axis erfolgt. Grundsätzlich wäre dieses Problem zwar durch eine Verkleinerung der fast-axis-Kollimationslinse lösbar. Durch die Verkleinerung der Apertur sowie der Brennweite würde dabei jedoch die Divergenz des kollimierten Strahlbündels in Richtung der fast-axis (y-Richtung) zunehmen. Hier bietet die Fourier-Teleskop-Anordnung die vorteilhafte Möglichkeit, mit dem ersten erfindungsgemäßen slow-axis-Zylinderlinsen-Array durch Verkleinerung des Abstands c sehr dicht, theoretisch bis zum Abstand 0, an die Emitter heranzurücken, ohne eine Verschlechterung der Kollimationswirkung in Kauf nehmen zu müssen. Dadurch ergibt sich zum einen ein äußerst kompakter Aufbau. Zum anderen bleibt dennoch die Möglichkeit erhalten, durch eine entsprechende Positionierung einer y-Zylinderlinse eine gute Kollimation in dieser Richtung zu erhalten.

Für die Brennweite $F_A$ wird beim Zylinderlinsen-Fourier-Teleskop eingesetzt:

$$F_A = \frac{P_x}{2 \tan\alpha_x}$$

Bevorzugt werden die Zylinderlinsen-Arrays einstückig ausgebildet. Dies bezieht sich sowohl auf die Teleskop- als auch die Fourier-Anordnung. Im einzelnen können das erste und das zweite Zylinderlinsen-Array jeweils für sich einstückig ausgebildet sein. Darüber hinaus ist es denkbar, die optisch aktiven Zylinderlinsenflächen des ersten und zweiten Zylinderlinsen-Arrays an einem monolithischen optischen Baustein anzubringen.

Eine bevorzugte Ausführungsform der Erfindung sieht vor, daß als fast-axis-Kollimator eine Zylinderlinse vor dem Emitter-Array angeordnet ist, deren Zylinderachse in y-Richtung liegt. Dieser fast-axis-Kollimator kann gleichfalls als Array ausgebildet sein und gegebenenfalls wiederum einstückig mit dem ersten und/oder zweiten Zylinderlinsen-Array ausgebildet sein. In diesem Zusammenhang sieht eine vorteilhafte Ausführungsform beispielsweise vor, daß ein erstes monolithisches optisches Element auf seiner den Emittern zugewandten Seite die Zylinderlinsenflächen des ersten Zylinderlinsen-Arrays zur x-Kollimation aufweist und auf seiner anderen Seite eine in y-Richtung durchgehenden Zylinderlinsenfläche zur Kollimation in dieser Richtung hat. Im Brennweitenabstand $F_A$ kann dann ein zweites erfindungsgemäßes x-Zylinderlinsen-Array positioniert werden. Damit ergibt sich eine extrem kompakte Bauweise für eine x-y-Kollimationsoptik, wobei die x-Divergenzreduktion über eine erfindungsgemäße Fourier-Teleskop-Anordnung erfolgt.

Vorzugsweise sind die Zylinderlinsen asphärisch ausgebildet. Die Abbildungsqualität in der Zwischenebene wird dadurch verbessert, daß die Divergenz der Leistung signifikant verringert wird. Die Breite des Strahlbündels überschreitet dabei nicht die maximale Apertur $P_x$.

Durch die erfindungsgemäß angegebenen Vorrichtungen gelingt die Umsetzung des erfindungsgemäß zugrundeliegenden neuartigen Kollimationsverfahrens zur Verwendung bei Emitter-Arrays, hier bevorzugt Hochleistungs-Diodenlaserbarren, bei denen $E_x/P_x$ häufig größer oder gleich 0,5 ist. Dieses Verfahren, das in Anspruch 8 definiert ist, sieht vor, daß mittels eines ersten Zylinderlinsen-Arrays das Strahlbündel der Breite $E_x$ jedes einzelnen Emitters auf den Mittenabstand $P_x$ aufgeweitet wird, wodurch eine virtuelle Quelle der Breite $P_x$ in einer Zwischenebene eines zweiten Zylinderlinsen-Arrays generiert wird. Der besondere Vorteil dieses erfindungsgemäßen Verfahrens liegt darin, daß für jeden einzelnen Emitter eine separate Kollimation vorgenommen wird.

Dabei sind das erste und das zweite Zylinderlinsen-Array in Fourier-Konfiguration angeordnet, wobei sich die beiden Zylinderlinsen-Arrays mit gleichen Brennweiten $F_A$ im Brennweitenabstand $F_A$ befinden.

Das erfindungsgemäße Verfahren überwindet die Beschränkungen, die sich aus der bisher üblichen Verwendung einzelner Zylinderlinsen-Arrays für jede Divergenzrichtung prinzipiell ergeben.

Ausführungsbeispiele der Erfindung werden im folgenden anhand der Zeichnungen näher erläutert. Es zeigen:

| | |
|---|---|
| Figur 1 | den Strahlengang eines Emitter-Arrays mit einer Kollimationsoptik in einer ersten Ausführungsform; |
| Figur 2 | den Strahlengang eines Emitter-Arrays mit einer erfindungsgemäßen Kollimationsoptik in einer zweiten Ausführungsform; |
| Figur 3 | eine perspektivische Ansicht einer erfindungsgemäß ausgestalteten Kollimationsoptik zur slow-axis-Kollimation; |
| Figur 3a | eine Kollimationsoptik wie in Figur 3 in einer weiteren Ausführungsform; |
| Figur 4 | eine perspektivische Ansicht einer erfindungsgemäß ausgestalteten Kollimationsoptik zur fast- und slow-axis Kollimation; |
| Figur 5 | eine perspektivische Ansicht einer erfindungsgemäß ausgestalteten Kollimationsoptik zur fast- und slow-axis Kollimation in einer zweiten Ausführungsform; |
| Figur 6 | den Strahlengang eines Emitter-Arrays mit einer erfindungsgemäßen Kollimationsoptik in einer dritten Ausführungsform; |
| Figur 7 a/b | schematisch den Strahlengang eines Emitter-Arrays mit einer erfindungsgemäßen Kollimationsoptik in einer vierten Ausführungsform. |

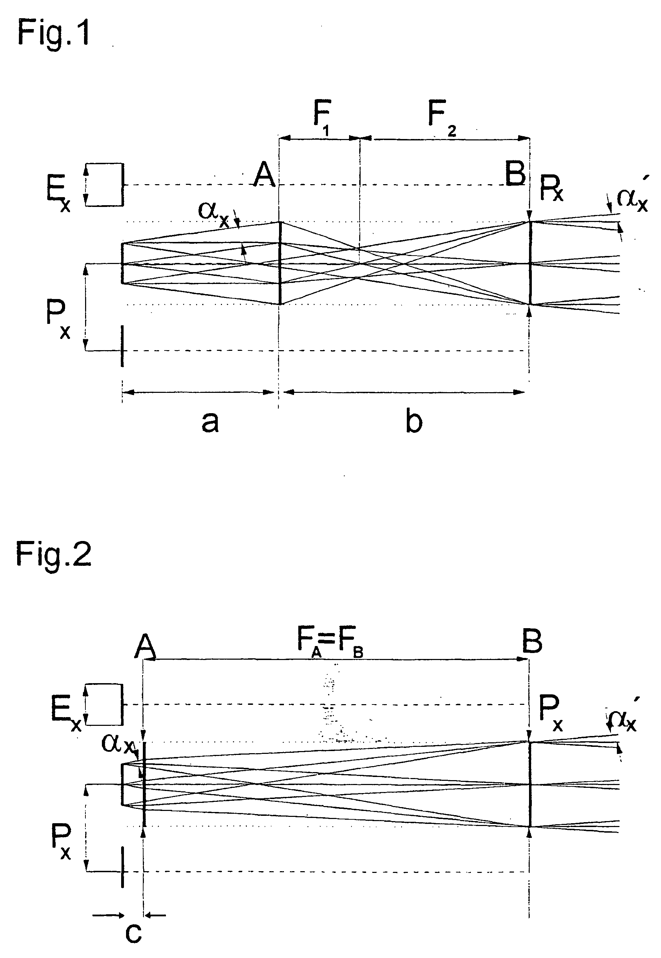

In Figur 1 ist eine Ansicht in Richtung der y-Achse auf ein Emitter-Array mit einer Vielzahl von in x-Richtung langgestreckten, linienförmigen Emissionsflächen E dargestellt, welche die Breite $E_x$ und einen Mittenabstand $P_x$ haben. Dies ist die typische Situation bei einem Diodenlaserbarren, wobei häufig $E_x/P_x \geq 0,5$ ist.

Die Divergenz in x-Richtung, also in der slow-axis, ist mit $\alpha_x$ bezeichnet. Aufgrund dieser Divergenz beginnen sich die Strahlbündel im Überlagerungsabstand a bei ungehinderter Ausbreitung zu überlagern.

Im Abstand a ist ein erstes Zylinderlinsen-Array A angebracht, dessen parallel angeordnete Zylinderlinsenflächen in y-Richtung liegen und eine Breite $P_x$ haben. Die Brennweite des Arrays A beträgt $F_1$.

Ein zweites Zylinderlinsen-Array B mit der Brennweite $F_2$ ist im Abstand $b = F_1 + F_2$ vom ersten Zylinderlinsen-Array A angeordnet, wobei es sich um eine Abbildungsebene von A bezüglich der Emitter E handelt. Mithin liegt eine klassische Teleskopanordnung vor.

Das kollimierte Ausgangsstrahlbündel hat eine reduzierte Divergenz $\alpha'_x$.

Figur 2 zeigt eine erfindungsgemäße Fourier-Teleskop-Anordnung, wobei das erste Zylinderlinsen-Array A mit der Brennweite $F_A$ dicht vor den Emittern angeordnet ist, das heißt der Abstand c klein ist zum Überlagerungsabstand a und zur Brennweite $F_A$.

Das zweite Zylinderlinsen-Array B mit derselben Brennweite $F_B = F_A$ ist in diesem Abstand vom ersten Zylinderlinsen-Array A positioniert, wodurch eine Fourier-Anordnung realisiert ist. Das Zylinderlinsen-Array B befindet sich nämlich in einer Zwischenebene des Teleskops.

Bei dieser Anordnung findet ebenfalls eine Divergenzreduktion von $\alpha_x$ auf $\alpha'_x$ statt.

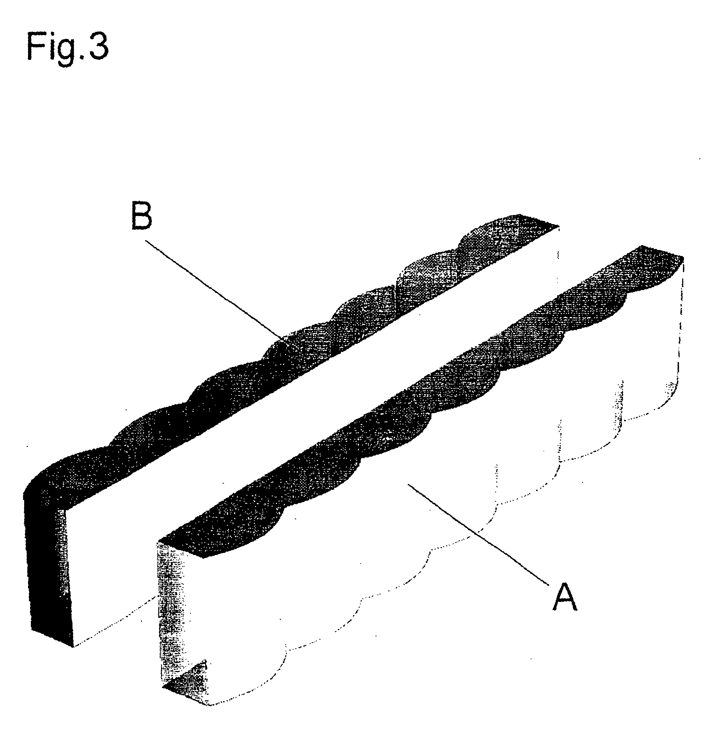

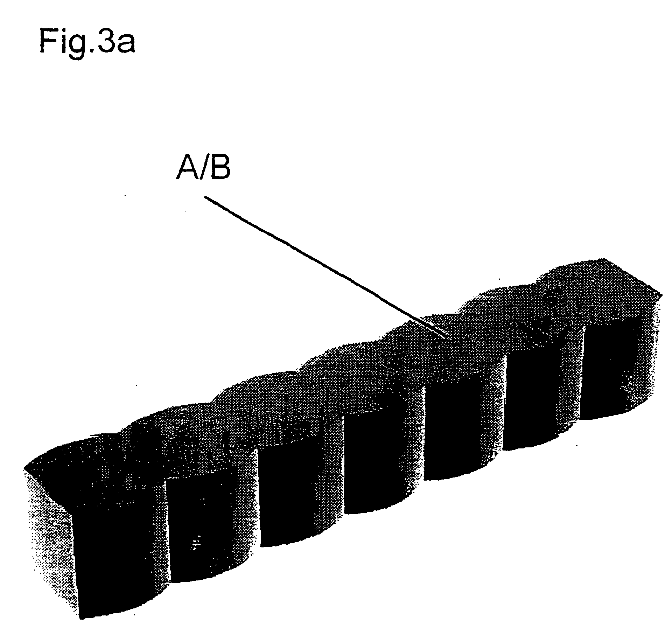

Figur 3 zeigt in perspektivischer Darstellung die Anordnung von zwei Zylinderlinsen-Arrays A und B gemäß Figur 1 oder Figur 2. Damit ist die Kollimation in der fast-axis (x-Richtung) durchführbar.

Die in Figur 3a dargestellt Ausführungsform unterscheidet sich von der Kollimatoreinrichtung gemäß Figur 3 dadurch, daß die beiden Zylinderlinsen-Arrays A und B in einem monolitischen Block A/B zusammengefaßt sind. Damit fallen in vorteilhafter Weise zwei optische Grenzflächen weg, welche bei einer separaten Ausgestaltung vorhanden sind.

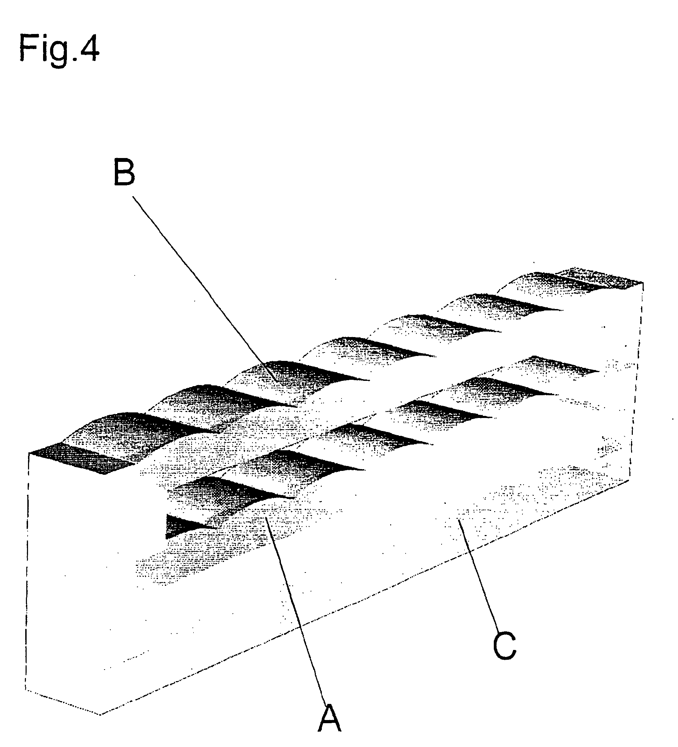

In Figur 4 ist eine vollständige fast- und slow-axis-Kollimationseinrichtung dargestellt. Vor dem ersten Zylinderlinsen-Array A ist dabei zur fast-axis-Kollimation eine Zylinderlinse C angebracht, deren Achse in y-Richtung liegt. Die beiden Zylinderlinsen-Arrays A und B sowie die Zylinderlinse C sind jeweils monolithisch ausgebildet und sind vorzugsweise asphärisch geformt.

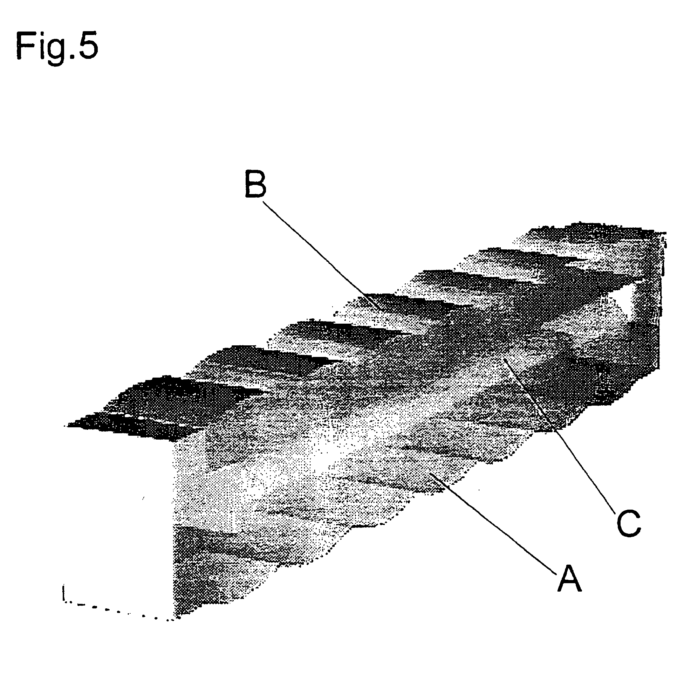

Figur 5 zeigt eine perspektivische Darstellung einer Kollimatoroptik in einer zweiten Ausführungsform. Man erkennt, wie die Zylinderlinsen-Arrays A und B jeweils monolithisch ausgebildet sind. Auf der Rückseite des Zylinderlinsen-Arrays A ist die Zylinderlinsenfläche C zur fast-axis-Kollimation (y-Richtung) einstückig angeformt.

Andere Ausführungsformen können vorsehen, die Zylinderlinsen-Array A und B an einem optischen Monolith-Baustein anzuformen und zur fast-axis-Kollimation eine separate Zylinderlinse bzw. ein Zylinderlinsen-Array vorzusehen.

Die Funktionsweise ist weiter oben bereits dargelegt worden.

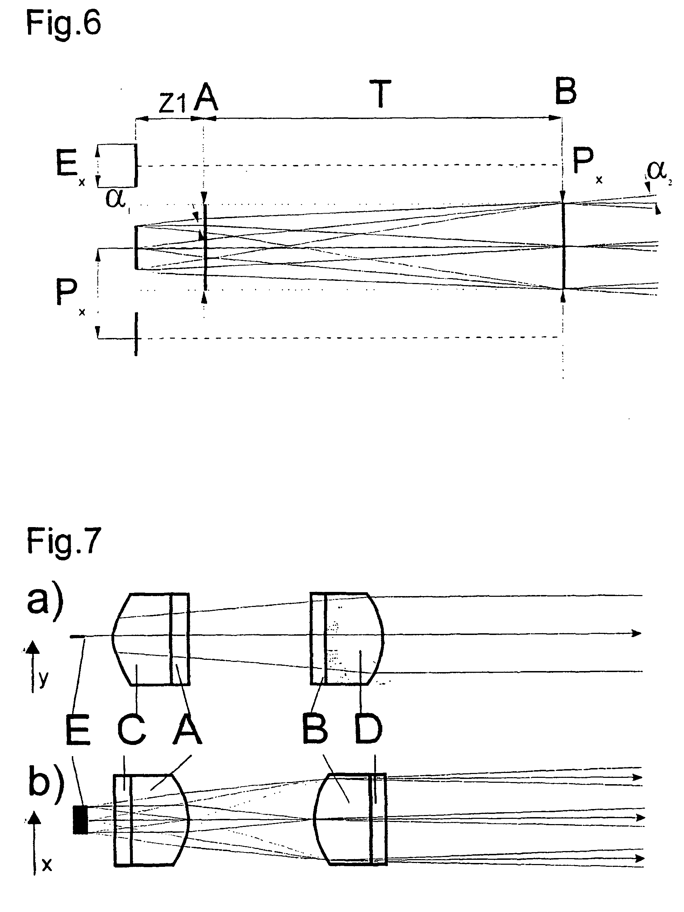

In Figur 6 ist der Strahlengang einer alternativen Ausgestaltung der Erfindung dargestellt, bei der die Arrays A und B ein Bikonvex-Linsensystem bilden. Das Array A bildet dabei den Fourier-Transformator, während das Array B die Feldlinse darstellt. Der Abstand der beiden Arrays A und B entspricht dem Hauptebenenabstand T der Bikonvex-Linsenanordnung, wobei $T = nF_A$ mit $n=1$ für Luft. Für die resultierende Brennweite $F_r$ der Bikonvex-Linsenanordnung gilt: $F_r = F_A$. Mit dem flexibel vorgebbaren Abstand $z_1$ zwischen den Emittern E und dem Array A ergibt sich für die Brennweite $F_B$ der Zusammenhang:

$$\frac{1}{F_B} = \frac{1}{F_A} - \frac{z_1}{F_A^2}$$

Figur 7 zeigt eine schematische Darstellung einer vollständigen erfindungsgemäßen Kollimationseinrichtung für die x-Richtung (slow-axis) und die y-Richtung (fast-axis). Figur 7a stellt die Kollimation der fast-axis (y-Richtung), Figur 7b die Kollimation der slow-axis (x-Richtung) dar. Besonders bei kleinen Emittern E und geringen Abständen $P_x$ kann eine Überlagerung der Emitterstrahlung in Richtung der slow-axis bereits in der Optik für die Kollimation der fast-axis erfolgen. Bei der dargestellten Ausführung wird dieses Problem dadurch gelöst, daß zunächst mit der Zylinderlinse C die Divergenz in Richtung der fast-axis reduziert wird und im zweiten Schritt die slow-axis-Divergenz mit der in Figur 6 beschriebenen Linsenkombination A B kollimiert wird. Im nächsten Schritt wird die Restdivergenz der fast-axis mit einer weiteren Zylinderlinse D reduziert. Diese Anordnung hat den besonderen Vorteil, daß durch die bereits kollimierte slow-axis die fast-axis-Divergenz bestmöglich reduziert werden kann. Dies wäre ohne eine vorherige slow-axis-Kollimation nicht möglich.

Durch die Zusammenfassung des Arrays A und der Zylinderlinse C bzw. des Arrays B und der Zylinderlinse D zu monolithischen Bausteinen werden maximal vier Linsenoberflächen für die bestmögliche Kollimation der linearen Emitter-Matrix E benötigt. Dies ist natürlich im Hinblick auf Verluste besonders vorteilhaft.

**Patentansprüche**

1. Optisches Emitter-Array mit Kollimationsoptik, bei dem eine Mehrzahl von ausgedehnten Emittern (E) in x-Richtung nebeneinander angeordnet ist, die in dieser Richtung eine definierte Divergenz $\alpha_x$, haben und deren Mittenabstände $P_x$ größer sind als die Emittergröße $E_x$, und bei dem die Kollimationsoptik ein vor dem Emitter-Array angeordnetes Zylinderlinsen-Array aufweist, mit einer Mehrzahl von sammelnden Zylinderlinsenflächen, die jeweils einem Emitter zugeordnet sind und deren Zylinderachsen in y-Richtung liegen, wobei ein erstes Zylinderlinsen-Array (A) mit der Brennweite $F_A$ innerhalb des Überlagerungsabstands a, in dem sich die von den Emittern (E) ausgehenden Strahlbündel überlagern, mit Abstand c, der klein ist gegenüber $F_A$, vor den Emittern (E) angeordnet ist, und wobei ein zweites Zylinderlinsen-Array (B) mit derselben Brennweite $F_A$ im Abstand dieser Brennweite $F_A$ zum ersten Zylinderlinsen-Array angeordnet ist.

2. Emitter-Array nach Anspruch 1, **dadurch gekennzeichnet, daß** für die Brennweite $F_A$ gilt:

$$F_A = \frac{P_x}{2\tan\alpha_x}$$

3. Emitter-Array nach einem der Ansprüche 1 oder 2, **dadurch gekennzeichnet, daß** die Zylinderlinsen-Arrays (A, B) einstückig ausgebildet sind.

4. Emitter-Array nach einem der Ansprüche 1 bis 3, **dadurch gekennzeichnet, daß** als fast-axis-Kollimator eine Zylinderlinse (C) vor dem Emitter-Array angeordnet ist, deren Zylinderachse in y-Richtung liegt.

5. Emitter-Array nach Anspruch 4, **dadurch gekennzeichnet, daß** der fast-axis-Kollimator (C) einstückig mit dem ersten und/oder zweiten Zylinderlinsen-Array (A, B) ausgebildet ist.

6. Emitter-Array nach einem der Ansprüche 1 bis 5, **dadurch gekennzeichnet, daß** die Zylinderlinsenflächen (A, B , C) asphärisch ausgebildet sind.

7. Emitter-Array nach einem der Ansprüche 1 bis 6, **dadurch gekennzeichnet, daß** es einen in x-Richtung liegenden Diodenlaserbarren aufweist.

8. Verfahren zur Kollimation der Strahlung eines Emitter-Arrays, bei dem eine Mehrzahl von ausgedehnten Emittern (E) in x-Richtung nebeneinander angeordnet ist, die in dieser Richtung eine definierte Divergenz $\alpha_x$ haben und deren Mittenabstände $P_x$ größer sind als die Emittergröße $E_x$, wobei mittels eines ersten Zylinderlinsen-Arrays (A) das Strahlbündel der Breite $E_x$ jedes einzelnen Emitters auf den Mittenabstand $P_x$ aufgeweitet wird, wodurch eine virtuelle Quelle der Breite $P_x$ in einer Zwischenebene eines zweiten Zylinderlinsen-Arrays (B) generiert wird, wobei das erste und das zweite Zylinderlinsen-Array (A, B) in Fourier-Konfiguration im Brennweitenabstand angeordnet sind.

9. Optisches Emitter-Array mit Kollimationsoptik, bei dem eine Mehrzahl von ausgedehnten Emittern (E) in x-Richtung nebeneinander angeordnet ist, die in dieser Richtung eine definierte Divergenz $\alpha_x$ haben und deren Mittenabstände $P_x$ größer sind als die Emittergröße $E_x$, und bei dem die Kollimationsoptik ein vor dem Emitter-Array angeordnetes Zylinderlinsen-Array aufweist, mit einer Mehrzahl von sammelnden Zylinderlinsenflächen, die jeweils einem Emitter zugeordnet sind und deren Zylinderachsen in y-Richtung liegen, wobei vor den Emittern E im Abstand $z_1$ der kleiner ist als der Überlagerungsabstand a, in dem sich die einzelnen von den Emittern E ausgehenden Strahlbündel überlagern, ein erstes Zylinderlinsen-Array (A) angeordnet ist, und im Abstand T vor dem Zylinderlinsen-Array (A) ein zweites Zylinderlinsen-Array (B), wobei die Zylinderlinsen des ersten und zweiten Arrays (A, B) zusammen eine Bikonvex-Linsenanordnung mit resultierender Brennweite $F_r = F_A$ und Hauptebenenabstand $T = F_A$ bilden.

10. Emitter-Array nach Anspruch 9, **dadurch gekennzeichnet, dass** für $F_A$, $F_B$ und $z_1$ gilt:

$$\frac{1}{F_B} = \frac{1}{F_A} - \frac{z_1}{F_A^2}$$

11. Emitter-Array nach einem der Ansprüche 9 oder 10, **dadurch gekennzeichnet, daß** zwischen den Emittern (E) und dem ersten Zylinderlinsen-Array (A) eine weitere Zylinderlinsenfläche (C) angeordnet ist, deren Zylinderachse in x-Richtung liegt.

12. Emitter-Array nach Anspruch 11, **dadurch gekennzeichnet, daß** das erste Zylinderlinsen-Array (A) und die weitere Zylinderlinsenfläche (C) zu einem monolithischen Baustein zusammengefaßt sind.

13. Emitter-Array nach einem der Ansprüche 9 bis 12, **dadurch gekennzeichnet, daß** zwischen dem ersten Zylinderlinsen-Array (A) und dem zweiten Zylinderlinsen-Array (B) eine zusätzliche Zylinderlinsenfläche (D) angeordnet ist, deren Zylinderachse in x-Richtung liegt.

14. Emitter-Array nach einem der Ansprüche 9 bis 12, **dadurch gekennzeichnet, daß** auf der von den Emittern(E) abgewandten Seite des ersten und zweiten Zylinderlinsen-Arrays (A, B) eine zusätzliche Zylinderfläche(D) angeordnet ist, deren Zylinderachse in x-Richtung liegt, so daß zumindest die Reduktion der Restdivergenz der fast-axis nach der Divergenzreduktion der slow-axis erfolgt.

15. Emitter-Array nach einem der Ansprüche 13 oder 14, **dadurch gekennzeichnet, daß** das zweite Zylinderlinsen-Array (B) und die zusätzliche Zylinderlinsenfläche (D) zu einem monolithischen Baustein zusammengefaßt sind.

16. Emitter-Array nach einem der Ansprüche 1 bis 15, **dadurch gekennzeichnet, daß** das erste und zweite Zylinderlinsen-Array (A, B) an einem monolithischen Baustein angeordnet sind.

**Claims**

1. Optical emitter array with a collimating optics unit in which a plurality of extended emitters (E) are arranged side by side in the x-direction, said emitters having a defined divergence $\alpha_x$ in that direction and their centre-to-centre distances $P_x$ are greater than the emitter dimension $E_x$, and in which the collimating optics unit comprises a cylindrical lens array arranged upstream of the emitter array and having a plurality of collecting cylindrical lens surfaces which each are associated with an emitter and the cylinder axes of which are positioned in the y-direction, a first cylindrical lens array (A) having the focal length $F_A$ being positioned upstream of the emitters (E) at a distance (c) which is small as compared with $F_A$ within the superposition range (a) in which the ray beams emitted by the emitters (E) are superposed, and a second cylindrical lens array (B) having the same focal length $F_A$ being arranged at a distance to the first cylindrical lens array, said distance corresponding to said focal length $F_A$.

2. Emitter array as claimed in claim 1, **characterised in that** the focal length $F_A$ is defined by:

$$F_A = \frac{P_x}{2 \tan\alpha_x}$$

3. Emitter array as claimed in any one of claims 1 or 2, **characterised in that** the cylindrical lens arrays (A, B) are formed in one piece.

4. Emitter array as claimed in any one of claims 1 to 3, **characterised in that** a cylindrical lens (C) is arranged as a fast axis collimator upstream of the emitter array, the cylinder axis of which lies in the y-direction.

5. Emitter array as claimed in claim 4, **characterised in that** the fast axis collimator (C) is formed integrally with the first and/or the second cylindrical lens array (A, B).

6. Emitter array as claimed in any one of claims 1 to 5, **characterised in that** the surfaces of the cylindrical lenses (A, B, C) are aspherical.

7. Emitter array as claimed in any one of claims 1 to 6, **characterised in that** it comprises a diode laser bar arranged in the x-direction.

8. Method of collimating the radiation of an emitter array in which a plurality of extended emitters (E) are arranged side by side in the x-direction, said emitters having a defined divergence $\alpha_x$ in that direction, and their centre-to-centre distances $P_x$ being greater than the emitter dimension $E_x$, the ray beam with the width $E_x$ of each individual emitter being expanded corresponding to the centre-to-centre distance $P_x$ by means of a first cylindrical lens array (A), by which means a virtual source having the width $P_x$ being generated in an intermediate plane of a second cylindrical lens array (B), and the first and the second cylindrical lens array (A, B) being arranged in a Fourier configuration at the focal length distance.

9. Optical emitter array with a collimating optics unit in which a plurality of extended emitters (E) are arranged side by side in the x-direction, said emitters having a defined divergence $\alpha_x$ in that direction and their centre-to-centre distances $P_x$ being greater than the emitter dimension $E_x$, and in which the collimating optics unit comprises a cylindrical lens array arranged upstream of the emitter array, with a plurality of collecting cylindrical lens surfaces which each are associated with an emitter and the cylinder axes of which are positioned in the y-direction, a first cylindrical lens array (A) being arranged upstream of the emitters E at a distance $z_1$ which is smaller than the superposition range (a) in which the individual ray beams emerging from the emitters E superpose each other, and a second cylindrical lens array (B) being arranged upstream of the cylindrical lens array (A) at a distance T, the cylindrical lenses of the first and of the second array (A, B) forming together a biconvex lens arrangement with a resulting focal length $F_r = F_A$ and a main plane distance $T=F_A$.

10. Emitter array as claimed in claim 9, **characterised in that** the following applies to $F_A$, $F_B$ and $z_1$:

$$\frac{1}{F_B} = \frac{1}{F_A} - \frac{z_1}{F_A^2}$$

11. Emitter array as claimed in any one of claims 9 or 10, **characterised in that** between the emitters (E) and the first cylindrical lens array (A) a further cylindrical lens surface (C) is arranged the cylinder axis of which lies in the x-direction.

12. Emitter array as claimed in claim 11, **characterised in that** the first cylindrical lens array (A) and the further cylindrical lens surface (C) are combined to a monolithic structural member.

13. Emitter array as claimed in any one of claims 9 to 12, **characterised in that** between the first cylindrical lens array (A) and the second cylindrical lens array (B) an additional cylindrical lens surface (D) is provided the cylinder axis of which lies in the x-direction.

14. Emitter array as claimed in any one of claims 9 to 12, **characterised in that** on the sides of the first cylindrical lens array and the second cylindrical lens array (A, B) turned away from the emitters (E) an additional cylindrical lens surface (D) is arranged, the cylinder axis of which lies in the x-direction so that at least the reduction of the residual divergence of the fast axis takes place after the divergence reduction of the slow axis.

15. Emitter array as claimed in one of claims 13 or 14, **characterised in that** the second cylindrical lens array (B) and the additional cylindrical lens surface (D) are combined to a monolithic structural member.

16. Emitter array as claimed in any one of claims 1 to 15, **characterised in that** the first and the second cylindrical lens array (A, B) are arranged at a monolithic structural member.

**Revendications**

1. Ensemble émetteur optique à système optique de collimation, dans lequel une pluralité d'émetteurs (E) extensifs sont disposés l'un à côté de l'autre suivant la direction x, lesquels présentent dans cette direction une divergence définie $\alpha x$, et leurs entraxes Px sont supérieurs à la grandeur des émetteurs Ex, et dans lequel le système optique de collimation présente un ensemble de lentilles cylindriques disposé devant l'ensemble émetteur, avec une pluralité de surfaces de lentilles cylindriques rassemblées, lesquelles sont disposées à chaque fois devant un émetteur et dont leurs axes cylindriques suivent la direction y, où un premier ensemble de lentilles cylindriques (A) ayant une distance focale $F_A$ dans la distance de superposition a, dans laquelle les extrémités des faisceaux de rayon se superposent à l'émetteur (E), avec la distance c, qui est plus petite que $F_A$, est disposée devant l'émetteur (E), et un second ensemble de lentilles cylindriques (B) ayant la même distance focale $F_A$ est disposé par rapport au premier ensemble de lentilles cylindriques dans l'intervalle de ladite distance focale $F_A$.

2. Ensemble émetteur selon la revendication 1, **caractérisé en ce que,** que pour la distance focale $F_A$ celui-ci équivaut à :

$$F_A = \frac{P_x}{2\tan\alpha_x}$$

3. Ensemble émetteur selon l'une des revendications 1 ou 2, **caractérisé en ce que,** l'ensemble de lentilles cylindriques (A, B) sont formés en une pièce.

4. Ensemble émetteur selon l'une des revendications de 1 à 3, **caractérisé en ce que,** en tant que collimateur d'axe rapide, une lentille cylindrique (C) est disposée devant l'ensemble émetteur, dont l'axe cylindrique se trouve suivant la direction y.

5.  Ensemble émetteur selon la revendication 4, **caractérisé en ce que,** le collimateur d'axe rapide (C) est formé en une pièce avec le premier et /ou second ensemble de lentilles cylindriques (A, B).

6.  Ensemble émetteur selon l'une des revendications de 1 à 5, **caractérisé en ce que,** les surfaces de lentilles cylindriques (A, B, C) sont formées d'une façon non-sphérique.

7.  Ensemble émetteur selon l'une des revendications de 1 à 6, **caractérisé en ce que,** celui-ci présente une barre laser à diode située suivant la direction x.

8.  Procédé pour la collimation de la radiation d'un ensemble émetteur, dans lesquels une pluralité d'émetteurs extensifs (E) sont disposés l'un à côté de l'autre suivant la direction x, lesquels présentent suivant cette direction une divergence définie αx et leurs entraxes Px sont supérieurs à la grandeur des émetteurs Ex, où moyennant un premier ensemble de lentilles cylindriques (A) le faisceau de rayon de la largeur Ex de chaque différent émetteur s'élargit sur les entraxes Px d'une telle façon qu'une largeur de source potentielle Px est générée sur un plan intermédiaire d'un second ensemble de lentilles cylindriques (B), où le premier et le second ensemble de lentilles cylindriques (A,B) sont disposés selon la configuration Fourier dans l'intervalle de distances focales.

9.  Ensemble émetteur optique à système optique de collimation, dans lequel une pluralité d'émetteurs extensifs (E) sont disposés l'un à côté de l'autre suivant la direction x, lesquels présentent dans cette direction une divergence définie αx et leurs entraxes Px sont supérieurs à la grandeur des émetteurs Ex, et dans lequel le système optique de collimation présente un ensemble de lentilles cylindriques disposé devant l'ensemble émetteur, avec une pluralité de surfaces de lentilles cylindriques rassemblées, où chacune d'entre-elles est associée à un émetteur et dont leurs axes cylindriques suivent la direction y, où un premier ensemble de lentilles cylindriques (A) est disposé devant les émetteurs E à la distance z1, laquelle est inférieure à la distance de superposition a, dans laquelle se superposent les différents faisceaux de rayon des émetteurs E, et sur la distance T, par rapport à l'ensemble de lentilles cylindriques (A), un second ensemble de lentilles cylindriques (B) est disposé, où les lentilles cylindriques du premier et du second ensemble (A, et B) forment de façon conjointe avec une distance focale $F_r = F_A$ et une distance de plan principale $T = F_A$, une disposition de lentilles biconvexes.

10. Ensemble émetteur selon la revendication 9, **caractérisé en ce que** $F_A$, $F_B$ et $z_1$ équivalent à :

$$\frac{1}{F_B} = \frac{1}{F_A} - \frac{z_1}{F_A^2}$$

11. Ensemble émetteur selon l'une des revendications 9 ou 10, **caractérisé en ce que**, entre l'émetteur (E) et le premier ensemble de lentilles cylindriques (A) est disposée une autre surface de lentilles cylindriques (C), dont l'axe cylindrique se trouve suivant la direction x.

12. Ensemble émetteur selon la revendication 11, **caractérisé en ce que,** le premier ensemble de lentilles cylindriques (A) et l'autre surface de lentilles cylindriques (C) sont réunis pour former un module monolithique.

13. Ensemble émetteur selon l'une des revendications de 9 à 12, **caractérisé en ce que,** entre le premier ensemble de lentilles cylindriques (A) et le second ensemble de lentilles cylindriques (B) une surface de lentilles cylindriques additionnelle (D) est disposée, dont l'axe cylindrique se trouve suivant la direction x.

14. Ensemble émetteur selon l'une des revendications de 9 à 12, **caractérisé en ce que,** sur le côté opposé du premier et second ensemble (A, B) de l'émetteur (E) une surface cylindrique (D) additionnelle est disposée, dont l'axe cylindrique se trouve suivant la direction x, de sorte que du moins la réduction de la divergence résiduelle de l'axe rapide vers la réduction de divergence de l'axe lent puisse être produite.

15. Ensemble émetteur selon l'une des revendications 13 ou 14, **caractérisé en ce que,** le second ensemble de lentilles cylindriques (B) et la surface de lentilles cylindriques additionnelle (D) sont réunis pour former un module monolithique.

**16.** Ensemble émetteur selon l'une des revendications de 1 à 15, **caractérisé en ce que,** le premier et second ensemble de lentilles cylindriques (A, et B) sont disposés sur un module monolithique.

Fig.1

Fig.2

# Fig.3

Fig.3a

A/B

Fig.4

## Fig.5

Fig.6

Fig.7

a)

b)